# EUROPÄISCHE PATENTSCHRIFT

(11) **EP 1 860 709 B1**
(45) Veröffentlichungstag und Bekanntmachung des Hinweises auf die Patenterteilung: **08.08.2012**
(21) Anmeldenummer: 06010719.0
(22) Anmeldetag: 24.05.2006
(51) Int. Cl.: H01L 51/30, C07F 17/02

(54) **Verwendung von quadratisch planaren Übergangsmetallkomplexen als Dotand**
Use of square planar transition metal complexes as dopants
Utilisation des complexes plans quadrangulaires à base des métaux de transition comme dopant

(43) Veröffentlichungstag der Anmeldung: 28.11.2007
(73) Patentinhaber: Novaled AG, 01307 Dresden (DE)
(72) Erfinder: Zeika, Olaf, 06727 Theissen (DE); Dathe, René, 09126 Chemnitz (DE); Willmann, Steffen, 01277 Dresden (DE); Werner, Ansgar, 01277 Dresden (DE)
(74) Vertreter: Bittner, Thomas L.

(56) Entgegenhaltungen:
- WO-A-2005/123754
- WO-A2-2005/086251
- JP-A- 3 208 689
- US-A1- 2004 241 492
- TAGUCHI ET AL: "Comparison of p-type and n-type organic field-effect transistors using nickel coordination compounds" CHEMICAL PHYSICS LETTERS, NORTH-HOLLAND, AMSTERDAM, NL, Bd. 421, Nr. 4-6, 15. April 2006 (2006-04-15), Seiten 395-398, XP005410175 ISSN: 0009-2614
- PEREIRA R P ET AL: "Electrosynthesis and characterisation of polypyrrole doped with [Bi(dmit)2]<->" SYNTHETIC METALS, ELSEVIER SEQUOIA, LAUSANNE, CH, Bd. 150, Nr. 1, 20. April 2005 (2005-04-20), Seiten 21-26, XP004891750 ISSN: 0379-6779

## Beschreibung

Die vorliegende Erfindung betrifft die Verwendung eines quadratisch planaren Übergangsmetallkomplexes als Dotand zur Dotierung eines organischen halbleitenden Matrixmaterials, als Ladungsinjektionsschicht, als Elektrodenmaterial und als Speichermaterial in elektronischen oder optoelektronischen Bauelementen.

Es ist bekannt organische Halbleiter durch Dotierung hinsichtlich ihrer elektrischen Eigenschaften, insbesondere ihrer elektrischen Leitfähigkeit, zu verändern, wie dies auch bei anorganischen Halbleitern, wie Siliciumhalbleitern, der Fall ist. Hierbei wird durch Erzeugung von Ladungsträgern im Matrixmaterial eine Erhöhung der zunächst recht niedrigen Leitfähigkeit sowie je nach Art des verwendeten Dotanden eine Veränderung im Fermi-Niveau des Halbleiters erreicht. Eine Dotierung führt hierbei zu einer Erhöhung der Leitfähigkeit von Ladungstransportschichten, wodurch ohmsche Verluste verringert werden, und zu einem verbesserten Übergang der Ladungsträger zwischen Kontakten und organischer Schicht.

Anorganische Dotanden wie Alkalimetalle (z.B. Cäsium) oder Lewis-Säuren (z.B. FeCl₃) sind bei organischen Matrixmaterialien aufgrund ihrer hohen Diffusionskoeffizienten meist nachteilig, da die Funktion und Stabilität der elektronischen Bauelemente beeinträchtigt wird. Weiterhin sind diese Materialen leicht flüchtig und fuhren so zu einer zunehmenden Verunreinigung der Verdampfungsapparatur. Ferner ist es bekannt, Dotanden über chemische Reaktionen in dem halbleitenden Matrixmaterial freizusetzen, um Dotanden bereitzustellen. Das Reduktionspotential der derart freigesetzten Dotanden ist jedoch für verschiedene Anwendungsfälle, wie insbesonders für organische Leuchtdioden (OLED), oftmals nicht ausreichend. Ferner werden bei Freisetzung der Dotanden auch weitere Verbindungen und/oder Atome, beispielsweise atomarer Wasserstoff, erzeugt, wodurch die Eigenschaften der dotierten Schicht bzw. des korrespondierenden elektronischen Bauelementes beeinträchtigt werden,

Das akzeptorartige Material kann auch als Löcherinjektionsschicht eingesetzt werden. So kann beispielsweise eine Schichtstruktur Anode/ Akzeptor/ Löchertransporter hergestellt werden. Dabei kann der Löchertransporter eine reine Schicht oder eine Mischschicht sein. Insbesondere kann der Löchertransporter ebenfalls mit einem Akzeptor dotiert sein. Die Anode kann beispielsweise ITO sein. Die Akzeptorschicht kann beispielsweise 0.5-100nm dick sein.

Quadratisch planare Übergangsmetallkomplexe sind beispielsweise aus der WO 2005/123754 A2 bekannt, die in einer großen Vielzahl von elektronischen Anwendungen verwendet werden können, beispielsweise in aktiven elektronischen Komponenten, passiven elektronischen Komponenten, in Elektrolumineszenzvorrichtungen (z.B. organischen lichtemittierenden Dioden), Photovoltaikzellen, lichtemittierenden Dioden, Feldeffekttransistoren, Phototransistoren, etc.. Der Einsatz der beschriebenen quadratisch planaren Übergangsmetallkomplexe wird als Ladungstransportmaterial angegeben.

Aus US 2004/241492 A1 ist ein elektrolumineszentes Element bekannt, das über eine Lochinjektionsschicht verfügt. Diese ist aus einem Polythiophen aufgebaut, das mit einem Nickel-Komplex dotiert sein kann.

JP 03208689 A offenbart Polythiophene, die mit bestimmten Nickeldithiolenen dotiert sind und als Datenspeicher eingesetzt werden können.

Aus T. Taguchi et al., Chemical Physics Letters 421 (2006) 395-398 sind organische Feldeffekttransistoren unter Verwendung von Metallkomplexen, Bis(4-methyl-1,2-phenylendiamino)nickel und Bis(dithiobenzyl)nickel, bekannt, deren Transistoreigenschaften an Luft und unter Vakuum gemessen wurden.

Aus WO 2005/086251 A2 ist die Verwendung eines Metallkomplexes als n-Dotand zur Dotierung eines organischen halbleitenden Matrixmaterials bekannt, wobei die Verbindung bezüglich des Matrixmaterials einen n-Dotanden darstellt. Als Dotandenverbindung wird ein neutraler elektronenreicher Metallkomplex mit einem Zentralatom als vorzugsweise neutrales oder geladenes Übergangsmetallatom mit einer Valenzelektronenzahl von zumindest 16 vorgeschlagen.

Aus der WO 2005/123754 A2 sind Ladungstransportmaterialien auf Basis von Übergangsmetallen bekannt, die eine Struktur der Formel I nach Anspruch 1 der WO 2005/123754 aufweisen können.

Der vorliegenden Erfindung liegt die Aufgabe zugrunde, verbesserte organische halbleitende Matrixmaterialien, Ladungsinjektionsschichten, Elektrodenmaterialien und Spcichermaterialien, insbesondere in elektronischen oder optoelektronischen Bauelementen, bereitzustellen. Insbesondere für dotierte organische halbleitende Matrixmaterialien sollen die als Dotand eingesetzten Verbindungen zu ausreichend hohen Reduktionspotentialen ohne störende Einflüsse für das Matrixmaterial selbst führen und eine wirksame Erhöhung der Ladungsträgeranzahl im Matrixmaterial bereitstellen und vergleichsweise einfach handhabbar sein.

Die erste Aufgabe wird dadurch gelöst, daß der quadratisch planare Übergatigsnietallkomplex eine der folgenden Strukturen (I) oder (II) aufweist; 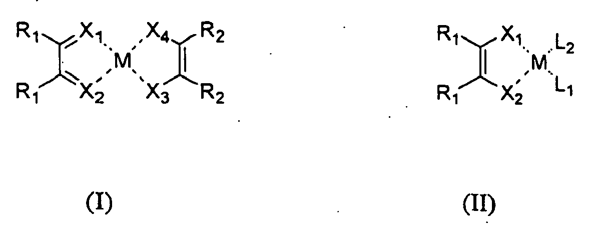 wobei M ein Übergangsmetall ist, das ausgewählt wird aus den Gruppen 8 bis 11 des Periodensystems der Elemente,
X₁, X₂, X₃ und X₄ unabhängig ausgewählt werden aus S, NR₅ und PR₅, wobei R₅ ausgewählt wird aus, substituiert oder unsubstituiert, linearem oder verzweigtem Alkyl, Cycloalkyl, Aryl, Heteroaryl, kondensierten aromatischen Ringen, Donorgruppen und Akzeptorgruppen,
R₁ und R₂ unabhängig ausgewählt werden aus, substituiert oder unsubstituiert, Aromaten, Heteroaromaten, aliphatischen Kohlenwasserstoffen, cycloaliphatischen Kohlenwasserstoffen und Nitril,
L₁ und L₂ unabhängig ausgewählt werden aus aromatischem Amin, aromatischem Phosphin, Halogen, Pseudohalogen, NCS, SCN und CN.

Bevorzugt wird M ausgewählt aus Nickel, Kupfer, Palladium, Platin, Eisen, Kobalt, Ruthenium und Osmium, vorzugsweise Nickel, Palladium, Platin und Eisen.

Auch ist vorgesehen, daß R₁ und R₂ ausgewählt werden aus substituiertem Phenyl, vorzugsweise Trifluormethylphenyl, Anisyl, Tolyl, 2-Pyridyl, Methyl, Propyl, Isopropyl, Trifluormethyl, Pentafluorethyl unhd Trichlormethyl.

Überraschenderweise wurde festgestellt, daß bei erfindungsgemäßer Verwendung der offenbarten Übergangsmetallkomplexe ein wesentlich stärkerer und/oder stabilerer Dotand als bei bisher bekannten Akzeptorverbindungen vorliegt, wobei die quadratisch planaren Übergangsmetallkomplexe hier in neutraler Form als ein p-Dotand gegenüber einem organischen halbleitenden Matrixmaterial eingesetzt werden. Insbesondere wird die Leitfähigkeit von Ladungstransportschichten bei erfindungsgemäßer Verwendung wesentlich erhöht und/oder der Übergang der Ladungsträger zwischen den Kontakten und organischer Schicht bei Anwendungen als elektronisches Bauelement wesentlich verbessert. Ohne durch diese Vorstellung eingeschränkt zu sein, wird davon ausgegangen, dass bei erfindungsgemäßer Verwendung der offenbarten Übergangsmetallkomplexe in einer dotierten Schicht CT-Komplexe gebildet werden, insbesondere durch den Transfer von mindestens einem Elektron vom jeweiligen umgebenden Matrixmaterial. Ebenso werden dabei Kationen des Matrixmaterials gebildet, die auf dem Matrixmaterial bewegliche Löcher aufweisen. Auf diese Weise gewinnt das Matrixmaterial eine Leitfähigkeit, die gegenüber der Leitfähigkeit des undotierten Matrixmaterials erhöht ist. Leitfähigkeiten von undotierten Matrixmaterialien betragen in der Regel < 10⁻⁸ S/cm, insbesondere häufig < 10⁻¹⁰ S/cm. Es ist dabei darauf zu achten, dass die Matrixmaterialien eine genügend hohe Reinheit aufweisen. Solche Reinheiten sind mit herkömmlichen Methoden, zum Beispiel Gradientensublimation, zu erreichen. Durch Dotierung lässt sich die Leitfähigkeit solcher Matrixmaterialien auf größer 10⁻⁸ S/cm, häufig > 10⁻⁵ S/cm erhöhen. Dies gilt insbesondere für Matrixmaterialien, die ein Oxidationspotential von größer als -0,5 V vs. Fc/Fc⁺, bevorzugt größer 0 V vs. Fc/Fc⁺, insbesondere größer +0.2 V vs. Fc/Fc⁺ aufweisen. Die Angabe Fc/Fc⁺ bezieht sich auf das Redoxpaar Ferrocen/ Ferrocenium, das als Referenz in einer elektrochemischen Potentialbestimmung, zum Beispiel Zyklovoltammetrie, eingesetzt wird.

Erfindungsgemäß wurde ferner festgestellt, daß die beschriebenen quadratisch planaren Übergangsmetallkomplexe als Injektionsschicht in elektronischen Bauteilen, vorzugsweise zwischen einer Elektrode und einer Halbleiterschicht, die auch dotiert sein kann, in elektronischen Bauelementen eingesetzt werden können. Die beschriebenen quadratisch planaren Übergangsmetallkomplexe können erfindungsgemäß auch als Teil einer Ladungsträgergenerationsschicht verwendet werden, beispielsweise durch Verwendung in einer Schicht, an die eine weitere p- oder n-dotierte Schicht angrenzt, Bei erfindungsgemäßer Verwendung stellen die beschriebenen planaren Übergangsverbindungen vorzugsweise isolierte Moleküle dar, die somit bevorzugt in der jeweiligen halbleitenden Schicht als isolierte Moleküle vorliegen, die nicht durch chemische Bindungen untereinander und/oder an eine Matrix oder an eine andere Komponente fixiert sind. Die Komplexe weisen eine überraschend hohe Stabilität in Bezug auf ihre Reaktivität mit der Atmosphäre auf.

### Syntheseverfahren

Quadratisch planare Übergangsmetallkomplexe, wie sie hierin beschrieben werden, lassen sich nach bekannten Verfahren synthetisieren, teilweise sind sie auch kommerziell erhältlich. Die Synthese solcher Verbindungen ist beispielsweise in folgenden Literaturstellen beschrieben, die hiermit jeweils vollumfänglich als Referenz in der Anmeldung mit eingeschlossen sind. Es versteht sich, dass die genannten Literaturstellen nur beispielhaft angegeben sind. Nach Schrauzer et al. lassen sich solche Übergangsmetallkomplexe aus 1,2-Diketonen oder 2-Hydroxyketonen, Phosphorpentasufid und einem geeigneten Übergangsmetallsalz herstellen, J. Am. Chem. Soc. (1965) 87/7 1483-9. Die Umsetzung von Übergangsmetall-Carbonylen mit Schwefel und Acetylenen führt ebenfalls zu den erfindungsgemäßen Komplexen, A. Davison et al. Inorg. Chem. (1964) 3/6 814. Anstatt der Übergangsmetall-Carbonyle können auch andere formal 0-wertige Übergangsmetallverbindungen, wie zum Beispiel entsprechenden Cyclooctadienyle, Phosphine, usw., aber auch reine Übergangsmetalle eingesetzt werden, G.N.Schrauzer et al. Z, Naturforschg. (1964) 19b, 192-8.

### Dotierung

Als p-dotierbare Matrixmaterialen können unter anderem Phthalocyaninkomplexe, beispielsweise des Zn (ZnPc), Cu (CuPc), Ni (NiPc) oder anderer Metalle, wobei der Phthalocyaninligand auch substituiert sein kann, eingesetzt werden. Auch andere Metallkomplexe von Naphthocyaninen und Porphyrinen können gegebenenfalls eingesetzt werden. Weiterhin können als Matrixmaterial auch arylierte oder heteroarylierte Amine bzw. Benzidinderivate eingesetzt werden, die substituiert oder unsubstituiert sein können, insbesondere auch Spiro-verknüpfte, beispielsweise TPD, α-NPD, TDATA, Spiro-TTB. Vorzugsweise kann NPD als Matrixmaterial verwendet werden.

| | | |
|---|---|---|
| 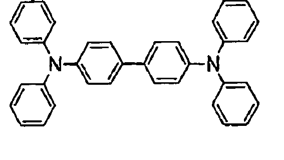 | 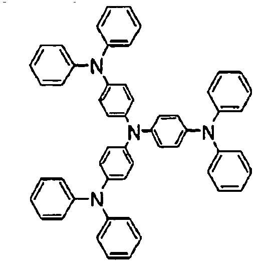 | 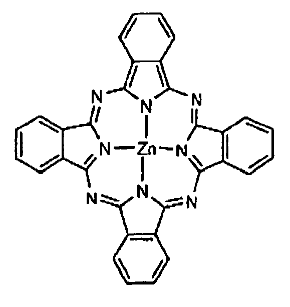 |
| TPD | TDATA | ZnPc |

Als Matrixmaterial können neben polyaromatischen Kohlenwasserstoffen auch Heteroaromaten, wie insbesondere Imidazol-, Thiophen-, Thiazolderivate, Heterotriphenylene, aber auch andere eingesetzt werden, gegebenenfalls auch dimere, oligomere bzw. polymere Heteroaromaten. Die Heteroaromaten sind vorzugsweise substituiert, insbesondere Aryl-substituiert, beispielsweise Phenyl- oder Naphthyl-substituiert. Sie können auch als Spiroverbindungen vorliegen.

Es versteht sich, dass die genannten Matrixmaterialien auch untereinander oder mit anderen Materialien gemischt im Rahmen der Erfindung einsetzbar sind. Es versteht sich, dass auch geeignete andere organische Matrixmaterialien verwendet werden können, die halbleitende, insbesondere löcherleitende Eigenschaften aufweisen.

### Dotierungskonzentration

Vorzugsweise liegt der Dotand in einer Dotierungskonzentration von ≤ 1:1 zu dem Matrixmolekül bzw. der monomeren Einheit eines polymeren Matrixmoleküls vor, wie in einer Dotierungskonzentration von 1:2 oder kleiner, besonders bevorzugt von 1:5 oder kleiner oder 1:10 oder kleiner. Die Dotierungskonzentration kann in dem Bereich von 20:1 bis 1:100.000, insbesondere in dem Bereich von 10:1 bis 1:1.000 liegen, bevorzugt in dem Bereich von 1:1 bis 1:100, ohne hierauf beschränkt zu sein.

### Durchführung der Dotierung

Die Dotierung des jeweiligen Matrixmaterials mit den erfindungsgemäß zu verwendenden Verbindungen kann durch eines oder eine Kombination der folgenden Verfahren erfolgen:
a) Mischverdampfung im Vakuum mit einer Quelle für das Matrixmaterial und einer für den Dotanden.
b) Sequentielles Deponieren des Matrixmaterials und des p-Dotanden auf einem Substrat mit anschließender Eindiffusion des Dotanden, insbesondere durch thermische Behandlung.
c) Dotierung einer Matrixschicht durch eine Lösung von p-Dotanden mit anschließendem Verdampfen des Lösungsmittels, insbesondere durch thermische Behandlung.
d) Oberflächendotierung einer Matrixmaterialschicht durch eine oberflächlich aufgebrachte Schicht von Dotanden .
e) Herstellung einer Lösung von Matrixmolekülen und Dotanden und anschließende Herstellung einer Schicht aus dieser Lösung mittels konventioneller Methoden wie beispielsweise Verdampfen des Lösungsmittels oder Aufschleudern.

Auf diese Weise können somit p-dotierte Schichten von organischen Halbleitern hergestellt werden, die vielfältig einsetzbar sind.

### Halbleitende Schicht

Mittels der erfindungsgemäß verwendeten elektronenarmen Übergangsmetallkomplexverbindungen können halbleitende Schichten erzeugt werden, die gegebenenfalls eher linienförmig ausgebildet sind, wie z.B. als Leitfähigkeitspfade, Kontakte oder dergleichen.

Mittels der erfindungsgemäß als p-Dotanden eingesetzten elektronenarmen Verbindungen können beispielsweise bei der Verwendung von Spiro-TTB oder ZnPc als Matrix halbleitende Schichten mit Leitfähigkeiten bei Raumtemperatur in dem Bereich von 10⁻⁵ S/cm oder höher erzielt werden, beispielsweise von 10⁻³ S/cm oder höher. Bei der Verwendung von Phthalocyanin-Zink als Matrix wurde eine Leitfähigkeit von höher 10⁻⁸ S/cm erzielt, beispielsweise 10⁻⁶ S/cm. Bisher war es nicht möglich, diese Matrix mit organischen Akzeptoren zu dotieren, da das Oxidationspotential der Matrix zu gering war. Die Leitfähigkeit von undotiertem Phthalocyanin-Zink beträgt hingegen maximal 10⁻¹⁰ S/cm.

Es versteht sich, dass die Schicht oder das Gebilde mit den Dotanden jeweils ein oder mehrere verschiedene derartige elektronenrarme Übergangsmetallkomplexverbindungen enthalten kann.

### Elektronisches Bauelement

Unter Verwendung der beschriebenen Verbindungen zur Herstellung p-dotierter organischer halbleitender Materialien, die insbesondere in Form von Schichten oder elektrischen Leitungspfaden angeordnet sein können, können eine Vielzahl elektronischer Bauelemente oder diese enthaltende Einrichtungen mit einer p-dotierten organischen Halbleiterschicht hergestellt werden. Im Sinne der Erfindung werden von dem Begriff "elektronische Bauelemente" auch optoelektronische Bauelemente mit umfasst. Durch die beschriebenen Verbindungen können die elektronischen Eigenschaften eines elektronisch funktionell wirksamen Bereichs des Bauelementes, wie dessen elektrische Leitfähigkeit, lichtemittierende Eigenschaften oder dergleichen, vorteilhaft verändert werden. So kann die Leitfähigkeit der dotierten Schichten verbessert und/oder die Verbesserung der Ladungsträgerinjektion von Kontakten in die dotierte Schicht erreicht werden.

Die Erfindung umfasst insbesondere organische lichtemittierende Dioden (OLED), organische Solarzellen, Feldeffekt-Transistoren, organische Dioden, insbesondere solche mit hohem Gleichrichtungsverhältnis wie 10³-10⁷, vorzugsweise 10⁴-10⁷ oder 10⁵-10⁷, und organische Feldeffekttransistoren, die mittels der elektronenarmen Übergangsmetallkomplexverbindungen hergestellt sind.

In dem elektronischen Bauelement kann eine p-dotierte Schicht auf Basis eines organischen Matrixmaterials beispielsweise in folgenden Schichtstrukturen vorliegen, wobei vorzugsweise die Basismaterialien oder Matrixmaterialien der einzelnen Schichten jeweils organisch sind:
p-i-M: p-dotierter Halbleiter-Isolator-Metall
M-i-p: Metall-Isolator-p-dotierter Halbleiter
p-i-n: p-dotierter Halbleiter-Isolator-n-dotierter Halbleiter,
n-i-p: n-dotierter Halbleiter-Isolator-p-dotierter Halbleiter.

"i" ist wiederum eine undotierte Schicht, "p" ist eine p-dotierte Schicht. Die Kontaktmaterialien sind hier löcherinjizierend, wobei p-seitig beispielsweise eine Schicht oder ein Kontakt aus ITO oder Au vorgesehen sein kann, oder elektroneninjizierend, wobei n-seitig eine Schicht oder ein Kontakt aus ITO, Al oder Ag vorgesehen sein kann.

In obigen Strukturen kann im Bedarfsfall auch die i-Schicht ausgelassen werden, wodurch Schichtenabfolgen mit p-n oder n-p-Übergängen erhalten werden können.

Die Verwendung der beschriebenen Verbindungen ist jedoch auf die oben genannten Ausführungsbeipiele nicht beschränkt, insbesondere können die Schichtstrukturen durch Einführung zusätzlicher geeigneter Schichten ergänzt bzw. modifiziert werden. Insbesondere können jeweils OLEDs mit derartigen Schichtabfolgen, insbesondere mit pin- oder mit einer dazu inversen Struktur, mit den beschriebenen Verbindungen aufgebaut werden.

Mit Hilfe der beschriebenen p-Dotanden können insbesondere organische Dioden vom Typ Metall-Isolator-p-dotierte Halbleiter (mip) oder auch gegebenenfalls vom pin-Typ hergestellt werden, beispielsweise auf der Basis von Phthalozyaninzink. Diese Dioden zeigen ein Rektifizierungsverhättnis von 10⁵ und höher. Ferner können unter Verwendung der erfindungsgemäßen Dotanden elektronische Bauelemente mit p-n-Übergängen erzeugt werden, wobei insbesondere für die p- und die n-dotierte Seite jeweils dasselbe Halbleitermaterial verwendet werden kann (Homo-p-n-Übergang), und wobei für das n-dotierte Halbleitermaterial eine beschriebene elektronenarme Übergangsmetallkomplexverbindung eingesetzt wird.

Die elektronenarmen Übergangsmetallkomplexverbindungen können erfindungsgemäß in den elektronischen Bauelementen aber auch in Schichten, Leitfähigkeitspfaden, Punktkontakten oder dergleichen eingesetzt werden, wenn diese gegenüber einer anderen Komponente überwiegen, beispielsweise als Injektionsschicht in reiner oder im wesentlichen reiner Form.

Weitere Aufgaben und Vorteile der vorliegenden Erfindung werden nun anschaulich anhand der folgenden Beispiele beschrieben, die lediglich veranschaulichend und nicht als den Umfang der Erfindung begrenzend zu betrachten sind.

### Anwendungsbeispiele

Es wird eine äußerst elektronenarme Übergangsmetallkomplexverbindung in hoher Reinheit bereitgestellt.

Die vorgelegte elektronenarme Übergangsmetallkomplexverbindung wird gleichzeitig mit dem Matrixmaterial verdampft. Gemäß dem Ausführungsbeispiel kann das Matrixmaterial z.B. Spiro-TTB oder α-NPD sein. Der p-Dotand und das Matrixmaterial können derart verdampft werden, dass die auf einem Substrat in einer Vakuumverdampfunesanlage niedergeschlagene Schicht ein Dotierungsverhältnis von p-Dotand zu Matrixmaterial von 1:10 aufweist.

Die jeweils mit dem p-Dotanden dotierte Schicht des organischen Halbleitermaterials ist auf einer ITO-Schicht (Indiumzinnoxid) aufgebracht, welche auf einem Glassubstrat angeordnet ist. Nach Aufbringung der p-dotierten organischen Halbleiterschicht wird eine Metallkathode aufgebracht, beispielsweise durch Aufdampfung eines geeigneten Metalls, um eine organische Leuchtdiode herzustellen. Es versteht sich, dass die organische Leuchtdiode auch einen sogenannten invertierten Schichtaufbau haben kann, wobei die Schichtenabfolge ist: Glassubstrat - Metallkathode -p-dotierte organische Schicht - transparente leitende Deckschicht (beispielsweise ITO). Es versteht sich, dass je nach Anwendungsfall zwischen den einzelnen genannten Schichten weitere Schichten vorgesehen sein können.

### Beispiel 1:

Der neutrale Nickelkomplex Bis(*cis*-1,2-bis[trifluormethyl]ethylen-1,2-dithiolato)nickel wurde zur Dotierung von Spiro-TTB als Matrixmaterial verwandt. Dotierte Schichten mit einem Dotierungsverhältnis Dotand : Matrixmaterial von 1 : 10 wurden durch Mischverdampfung von Matrix und Dotand mit Spiro-TTB hergestellt. Die Leitfähigkeit betrug 2x10⁻⁴S/cm.

### Beispiel 2:

Der neutrale Nickelkomplex Bis(*cis*-1,2-bis[trifluormethyl]ethylen-1,2-dithiolato)nickel wurde zur Dotierung von α-NPD als Matrixmaterial verwandt. Dotierte Schichten mit einem Dotierungsverhältnis Dotand : Matrixmaterial von 1 : 10 wurden durch Mischverdampfung von Matrix und Dotand mit α-NPD hergestellt. Die Leitfähigkeit betrug 2x10⁻⁷S/cm.

### Beispiel 3:

Der neutrale Cobaltkomplex Bis(*cis*-1,2-bis[trifluormethyl]ethylen-1,2-dithiolato)cobalt wurde zur Dotierung von ZnPc als Matrixmaterial verwandt. Dotierte Schichten mit einem Dotierungsverhältnis Dotand : Matrixmaterial von 1 : 10 wurden durch Mischverdampfung von Matrix und Dotand mit ZnPc hergestellt. Die Leitfähigkeit betrug 2x10⁻⁴S/cm.

### Beisipiel 4:

Der neutrale Eisenkomplex Bis(*cis*-1,2-bis[trifluormethyl]ethylen-1,2-dithiolato)eisen wurde zur Dotierung von ZnPc als Matrixmaterial verwandt. Dotierte Schichten mit einem Dotierungsverhältnis Dotand : Matrixmaterial von 1 : 10 wurden durch Mischverdampfung von Matrix und Dotand mit ZnPc hergestellt. Die Leitfähigkeit betrug 3x10⁻³S/cm,

### Beispiel 5:

Der neutrale Nickelkomplex Bis(*cis*-1,2-bis[2,2'-pyridyl]ethylen-1,2-dithiolato)nickel wurde zur Dotierung von ZnPc als Matrixmaterial verwandt. Dotierte Schichten mit einem Dotierungsverhältnis Dotand : Matrixmaterial von 1 : 10 wurden durch Mischverdampfung von Matrix und Dotand mit ZnPc hergestellt. Die Leitfähigkeit betrug 4x10⁻⁵S/cm.

## Patentansprüche

1. Verwendung eines quadratisch planaren Übergangsmetallkomplexes als elektrischer Dotand zur Dotierung eines organischen halbleitenden Matrixmaterials, als Ladungsinjektionsschicht, als Elektrodenmaterial in elektronischen oder optoelektronischen Bauelementen oder als Speichermaterial in elektronischen Bauelementen, **dadurch gekennzeichnet, daß** der quadratisch planare Übergangsmetallkomplex eine der folgenden Strukturen (I) oder (II) aufweist: 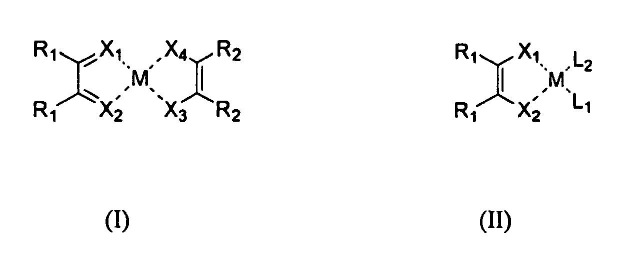 wobei M ein Übergangsmetall ist, das ausgewählt wird aus den Gruppen 8 bis 11 des Periodensystems der Elemente,
X₁, X₂, X₃ und X₄ unabhängig ausgewählt werden aus S, NR₅ und PR₅, wobei R₅ ausgewählt wird aus substituiert oder unsubstituiert, linearem oder verzweigtem Alkyl, Cycloalkyl, Aryl, Heteroaryl, kondensierten aromatischen Ringen, Donorgruppen und Akzeptorgruppen,
R₁ und R₂ unabhängig ausgewählt werden aus substituierten oder unsubstituierten, Aromaten, Heteroaromaten, aliphatischen Kohlenwasserstoffen, cycloaliphatischen Kohlenwasserstoffen und Nitril,
L₁ und L₂ unabhängig ausgewählt werden aus aromatischem Amin, aromatischem Phosphin, Halogen, Pseudohalogen, NCS, SCN und CN.

2. Verwendung nach Anspruch 1, **dadurch gekennzeichnet, daß** M ausgewählt wird aus Nickel, Kupfer, Palladium, Platin, Eisen, Kobalt, Ruthenium und Osmium, vorzugsweise Nickel, Palladium, Platin und Eisen.

3. Verwendung nach Anspruch 1 oder 2, **dadurch gekennzeichnet, daß** R₁ und R₂ ausgewählt werden aus substituiertem Phenyl, vorzugsweise Trifluormethylphenyl, Anisyl, Tolyl, 2-Pyridyl, Methyl, Propyl, Isopropyl, Trifluormethyl, Pentafluorethyl und Trichlormethyl.

## Claims

1. Use of a square planar transition metal complex as electronic dopant for doping an organic semiconductive matrix material, as charge injection layer, as electrode material in electronic components or optoelectronic components or as storage material in electronic components, **characterized in that** the square planar transition metal complex has one of the following structures (I) or (II): 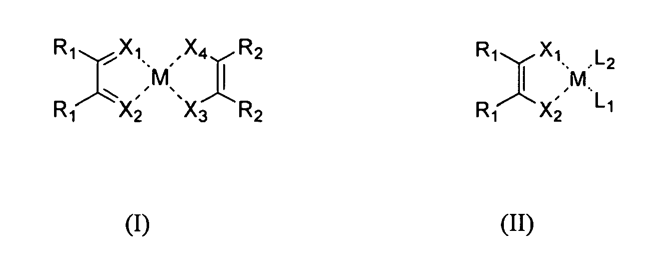 wherein M is a transition metal selected from the groups 8 to 11 of the periodic system of the elements,
X₁, X₂, X₃ and X₄ are independently selected from S, NR₅ und PR₅, wherein R₅ is selected from, substituted or unsubstituted, linear or branched alkyl, cycloalkyl, aryl, heteroaryl, condensed aromatic rings, donor groups and acceptor groups,
R₁ and R₂ are independently selected from substituted or unsubstituted aromatic, heteroaromatic compounds, aliphatic hydrocarbons, cycloaliphatic hydrocarbons, and nitrile,
L₁ and L₂ are independently selected from aromatic amine, aromatic phosphine, halogen, pseudohalogen, NCS, SCN and CN.

2. Use according to claim 1, **characterized in that** M is selected from nickel, copper, palladium, platinum, iron, cobalt, ruthenium and osmium, preferably nickel, palladium, platinum and iron.

3. Use according to claim 1 or 2, **characterized in that** R₁ und R₂ are selected from substituted phenyl, preferably trifluoromethylphenyl, anisyl, tolyl, 2-pyridyl, methyl, propyl, isopropyl, trifluoromethyl, pentafluoroethyl and trichloromethyl.

## Revendications

1. Utilisation d'un complexe de métal de transition à géométrie plan-carré en tant que dopant électrique, pour ainsi doper un matériau de matrice semi-conducteur organique, en tant que couche d'injection de charges, en tant que matériau d'électrode dans des composants électroniques ou optoélectroniques, ou bien en tant que matériau de mémoire dans des composants électroniques, **caractérisée en ce que** ledit complexe de métal de transition à géométrie plan-carré présente l'une des structures (I) ou (II) suivantes : 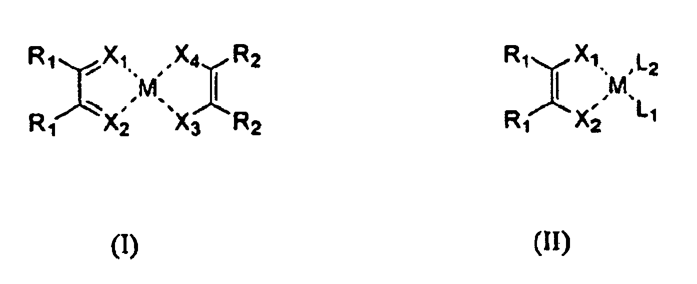 M étant un métal de transition choisi dans les groupes 8 à 11 du tableau périodique des éléments,
X₁, X₂, X₃ et X₄ étant choisis, de façon indépendante, parmi S, NR₅ et PR₅, R₅ étant choisi parmi les alkyles, cycloalkyles, aryles, hétéroaryles linéaires ou ramifiés, substitués ou non-substitués, les anneaux aromatiques condensés, les groupes donneurs et les groupes accepteurs,
R₁ et R₂ étant choisis, de façon indépendante, parmi les composés aromatiques, les hétérocycles aromatiques, les hydrocarbures aliphatiques, les hydrocarbures cycloaliphatiques, substitués ou non-substitués, et les nitriles.
L₁ et L₂ étant choisis, de façon indépendante, parmi les amines aromatiques, les phosphines aromatiques, les halogènes, les pseudohalogènes, NCS, SCN et CN.

2. Utilisation selon la revendication 1, **caractérisée en ce que** M est choisi parmi le nickel, le cuivre, le palladium, le platine, le fer, le cobalt, le ruthénium et l'osmium, de préférence parmi le nickel, le palladium, le platine et le fer.

3. Utilisation selon les revendications 1 ou 2, **caractérisée en ce que** R₁ et R₂ sont choisis parmi les phényles substitués, de préférence parmi le trifluorométhylphényle, l'anisyle, le tolyle, le 2-pyridyle, le méthyle, le propyle, l'isopropyle, le trifluorométhyle, le pentafluorométhyle et le trichlorométhyle.
